# EUROPÄISCHE PATENTSCHRIFT

(11) **EP 1 203 517 B1**
(45) Veröffentlichungstag und Bekanntmachung des Hinweises auf die Patenterteilung: **17.09.2003**
(21) Anmeldenummer: 00962178.0
(22) Anmeldetag: 31.07.2000
(51) Int. Cl.: H05K 13/02

(54) **FREILEGEVORRICHTUNG AN EINEM GURTFÖRDERER EINER BESTÜCKANLAGE UND VERFAHREN ZUM BESTÜCKEN UNTER VERWENDUNG DER FREILEGEVORRICHTUNG**
UNCOVERING DEVICE ON A BELT CONVEYER OF A PICK-AND-PLACE INSTALLATION AND METHOD FOR PICKING AND PLACING COMPONENTS USING THE SAME
DISPOSITIF DE DEGARNISSAGE SUR UN CONVOYEUR A COURROIE D'UNE INSTALLATION D'EQUIPEMENT, ET PROCEDE D'EQUIPEMENT UTILISANT CE DISPOSITIF

(30) Priorität: 29.07.1999 DE 19935818
(43) Veröffentlichungstag der Anmeldung: 08.05.2002
(73) Patentinhaber: SIEMENS AKTIENGESELLSCHAFT, 80333 München (DE)
(72) Erfinder: ESCHENWECK, Friedrich, D-81927 München (DE)
(86) Internationale Anmeldenummer: DE0002524
(87) Internationale Veröffentlichungsnummer: WO01010183

(56) Entgegenhaltungen:
- EP-A- 0 817 560
- JP-A- 11 008 492
- JP-A- 11 186 788

## Beschreibung

Die Erfindung betrifft eine Freilegevorrichtung an einem Gurtförderer einer Bestückanlage mit einem mit Bestückelementen beladenen Transportband und einer Entnahmeeinrichtung zur Entnahme von Bestückelementen. Ferner betrifft die Erfindung ein Verfahren zum Bestücken unter Verwendung der Freilegevorrichtung.

Es sind Anordnungen zum Bestücken bekannt mit einem Transportband, das Vertiefungen aufweist, in denen sich Bestückelemente befinden. Um die Bestückelemente am Herausfallen aus der Vertiefungen zu hindern und sie vor Umwelteinflüssen zu schützen, sind die Vertiefungen mit einer flexiblen Abdeckung abgedeckt. Diese Abdeckung wird am Anfang des Transportbandes abgezogen, damit eine Entnahmeeinrichtung das in der ersten nicht abgedeckten Vertiefung befindliche Bestückelement entnehmen kann. Nach Entnahme des Bestückelementes durch die Entnahmeeinrichtung fährt das Transportband bei festgehaltener Folie um eine Vertiefung weiter, so daß sich erneut eine mit einem Bestückelement gefüllte Vertiefung unterhalb der Entnahmeeinrichtung befindet und der nächste Entnahmevorgang beginnen kann. Nach der Entnahme einer bestimmten Anzahl von Bestückelementen bewegt sich die Entnahmeeinrichtung zu einem weiteren Transportband, um dort weitere Bestückelemente zu entnehmen. Nach dem Ablauf eines oder mehrerer weiterer Entnahmevorgänge bei einem oder mehreren weiteren Transportbändern kehrt die Entnahmeeinrichtung schließlich zum ersten Transportband zurück und der Vorgang beginnt von neuem. Die Entnahme erfolgt dabei bei jedem Transportband jeweils in einer festen Position. Das Transportband wird mit einer Verfahrgeschwindigkeit bewegt, wodurch die Vertiefungen mit einer Justiergenauigkeit auf vorgegebene Positionen gefahren werden können. Dabei ist die Entnahmeeinrichtung in Bezug auf Justiergenauigkeit und Verfahrgeschwindigkeit dem Transportband weit überlegen.

Aus EP-A-0 817 560 ist ein Gurtförderer mit einer Freilegevorrichtung bekannt, die eine in Förderrichtung verschiebbare, starre Abdechung aufweist. Demnach haben die bekannten Anordnungen zum Bestücken den Nachteil, daß die Taktzeit, mit der die Bestückelemente den Vertiefungen entnommen werden können von dem Transportband als dem langsamsten Glied der Kette begrenzt werden. Eine weitere Verkürzung der Entnahmetaktzeit, die wegen der Schnelligkeit der Entnahmeeinrichtung prinzipiell möglich wäre, ist mit der bekannten Freilegevorrichtung nicht erreichbar.

Ziel der vorliegenden Erfindung ist es daher, eine Freilegevorrichtung für einen Gurtförderer einer Bestückanlage bereitzustellen, die es ermöglicht, die Taktzeit der Entnahme von Bestückelementen der die Dynamik der Entnahmeeinrichtung anzupassen.

Dieses Ziel wird erfindungsgemäß durch eine Freilegevorrichtung nach Anspruch 1 erreicht. Vorteilhafte Ausgestaltungen der Freilegevorrichtung sowie Verfahren zum Bestücken unter Verwendung der Freilegevorrichtung sind den weiteren Ansprüchen zu entnehmen.

Die Erfindung gibt einen Gurtförderer für eine Bestückanlage an, wie in Anspruch 1 definiert.

Hierzu ist die starre Abdeckung bevorzugt in ihrer Länge variabel einstellbar ausgebildet, beispielsweise teleskopartig. Dadurch ist es mit der erfindungsgemäßen Freilegevorrichtung durch Einstellen der Länge möglich, Bestückelemente, welche nur noch von der starren Abdeckung bedeckt sind, sukzessiv freizulegen.

Durch die erfindungsgemäße Abdeckung eines Teiles der Bestückelemente mit einer starren Abdeckung, die an die flexible Abdeckung gekoppelt sein kann, wird es möglich, die Bestückelemente durch die Entnahmeeinrichtung an verschiedenen Positionen relativ zum feststehenden Transportband zu entnehmen. Die starre Abdeckung verhindert dabei, daß die Bestückelemente vom Transportband vor der Entnahme durch die Entnahmeeinrichtung heraus- oder herunterfallen. Die Entnahme von Bestückelementen aus verschiedenen Positionen wird darüber hinaus ohne Verschiebung des Transportbandes, was der zeitkritische Faktor ist, ermöglicht. Auch durch die mögliche Kopplung der starren Abdeckung an die flexible Abdeckung können Bestückelemente neben der verschiebbaren starren Abdeckung und der in der Länge variabel einstellbaren starren Abdeckung ohne Verschiebung des Transportbandes freigelegt werden.

Besonders vorteilhaft ist eine Freilegevorrichtung an einem Gurtförderer einer Bestückanlage, bei der die Bestückelemente in Vertiefungen des Transportbandes angeordnet sind. Dadurch können die Bestückelemente durch einfaches Einlegen in die Vertiefungen in definierten Abständen am Transportband angebracht werden, ohne Verwendung von Klebstoffen oder ähnlichem.

Besonders vorteilhaft ist eine Realisierung der Kopplung zwischen flexibler und starrer Abdeckung, bei der erfindungsgemäß die starre Abdeckung eine Ausnehmung aufweist, durch die die flexible Abdeckung an der Abziehposition auf die vom Transportband abgewandten Seiten der starren Abdeckung durchgeführt ist. Eine solche Kopplung ist besonders leicht und kostengünstig zu realisieren.

Weiterhin ist es besonders vorteilhaft, die starre Abdeckung an einen ihre Bewegung steuernden Linearmotor, der beispielsweise in die Abdeckung integriert sein kann, oder einen Hubmagneten zu koppeln. Eine solche einfache und kostengünstige Variante ist für die Bewegung der starren Abdeckung völlig ausreichend, da diese nicht mit der gleichen Genauigkeit wie das Transportband verschoben werden muß. Die starre Abdeckung hat beispielsweise im Falle von Vertiefungen im Transportband nur dafür zu sorgen, daß die Bestückelemente nicht aus den Vertiefungen herausfallen. Da die Vertiefungen typischerweise eine der Länge der Bestückelemente entsprechende Länge aufweisen, genügt eine Positioniergenauigkeit für die starre Abdeckung von etwa einem Drittel der Länge der Vertiefungen. Demgegenüber müßte, um eine Entnahme durch die Entnahmeeinrichtung zu ermöglichen, das Transportband mit einer Genauigkeit von beispielsweise einem Zehntel der Positioniergenauigkeit der starren Abdeckung unter die Entnahmeeinrichtung positioniert werden. Die derzeit verfügbaren Bestückelemente haben Abmessung von minimal 0,1mm* 0,1mm* 0,2mm, wobei eine weitere Miniaturisierung zu erwarten ist.

Besonders vorteilhaft ist es, die flexible Abdeckung als Klebefolie auszuführen. Eine solche Klebefolie verhindert ein Herausfallen der Bestückelemente und sorgt zugleich für eine Haftung der flexiblen Abdeckung auf dem Transportband und evtl. auf den Bestückelementen.

Weiterhin gibt die Erfindung ein Verfahren zum Bestücken unter Verwendung der erfindungsgemäßen Freilegevorrichtung an, bei dem von der starren Abdeckung zunächst das am weitesten von der Abziehposition entfernte Bestückelement freigelegt wird. Ausgehend von der Startposition in dem Entnahmeabschnitt über dem von der starren Abdeckung freigelegten Bestückelement bewegt sich die Entnahmeeinrichtung in Richtung Abziehposition hin zu einer Endposition. Im Verlaufe dieser Bewegung gibt die starre Abdeckung sukzessive eine Anzahl von insgesamt n Bestückelemente, wie sie für einen Bestückzyklus benötigt wird, frei, die von der Entnahmeeinrichtung entnommen werden.

Entsprechend der vorteilhaften Freilegevorrichtung an einem Gurtförderer einer Bestückanlage mit einem Transportband, das Vertiefungen aufweist, ist auch das Verfahren besonders vorteilhaft, bei dem die Bestückelemente aus Vertiefungen des Transportbandes entnommen werden.

Weiterhin ist in einem zyklischen Verfahren, bei dem die Entnahmeeinrichtung nur eine beschränkte Wegstrecke entlang des Transportbandes zurücklegen kann besonders vorteilhaft, wenn nach Entnahme des n-ten Bestückelementes die Entnahmeeinrichtung zur Startposition zurückkehrt und das Transportband zusammen mit der starren und der flexiblen Abdeckung um eine entsprechende Strecke in gleicher Richtung verschoben wird. Nach der Rückkehr der Entnahmeeinrichtung zum ersten Transportband kann nun erneut mit dem Entnahmeprozeß begonnen werden.

Im folgenden wird die Erfindung anhand eines Ausführungsbeispiels und der dazugehörigen Zeichnung näher erläutert.
Figur 1 zeigt eine erfindungsgemäße Freilegevorrichtung an einem Gurtförderer einer Bestückanlage im schematischem Längsschnitt,
Figur 2 zeigt einen Querschnitt der starren Abdeckung nach einer bevorzugten Ausführungsform der Erfindung, und
Figur 3 zeigt einen Schnitt entlang Linie I-I aus Figur 2.

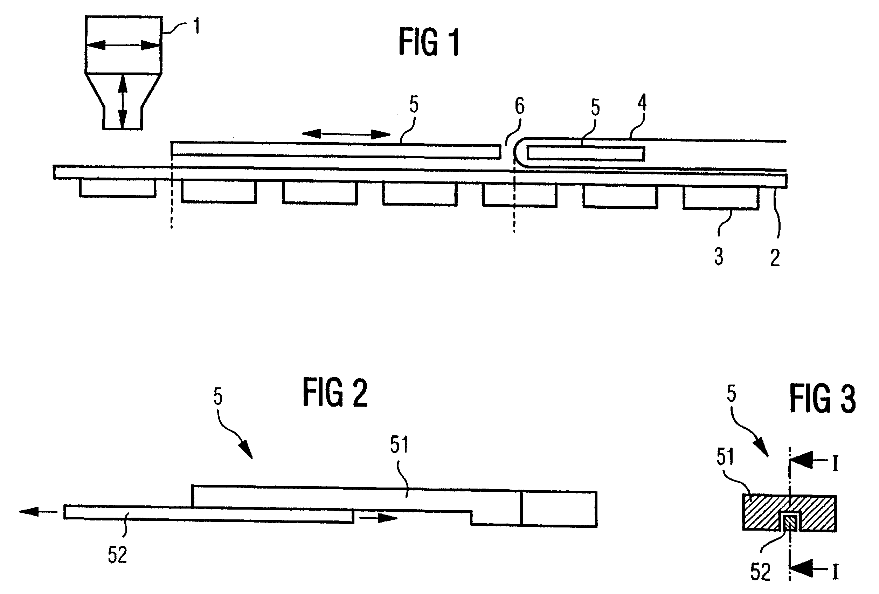

Die Figur 1 zeigt eine erfindungsgemäße Freilegevorrichtung an einem Gurtförderer einer Bestückanlage mit einem Bestückkopf 1 und einem Gurt 2, der Gurttaschen 3 aufweist und von einer Folie 4 bzw. einer starren Abdeckung 5 abgedeckt ist. Die Abdeckung 5 weist eine Ausnehmung 6 auf, durch die die Folie von der einen Seite der Abdeckung 5 auf die andere Seite der Abdeckung 5 geführt ist. Die Abdeckung 5 ist längs zum Gurt 2 bewegbar und zieht bei dieser Bewegung gleichzeitig die Folie 4 vom Gurt 2 ab. Der Bestückkopf 1 ist quer zum Gurt 2 bewegbar und kann somit Bestückelemente (nicht in der Figur dargestellt) den Gurttaschen 3 an verschiedenen Positionen entnehmen. Darüber hinaus ist der Bestückkopf 1 senkrecht zum Gurt 2 bewegbar, um die aus den Gurttaschen 3 entnommenen Bauelemente (nicht in der Figur dargestellt) zu entnehmen und beispielsweise auf einer Platine zu montieren.

Aus Figur 2 ist eine weitere mögliche Ausgestaltung der starren Abdeckung 5 ersichtlich. Gezeigt ist lediglich der Abschnitt der starren Abdeckung, welcher ab der Abziehposition in dem Entnahmeabschnitt angeordnet ist (siehe Figur 1). Die starre Abdeckung ist hierbei mit einem Rumpf 51 und einem Teleskopstück 52 versehen. Das Teleskopstück 52 ist relativ zu dem Rumpf 51 bewegbar. Die Breite des Teleskopstücks 52 in Querrichtung des Transportbandes 2 (aus Figur 1 ersichtlich) ist sehr gering im Vergleich zu der Abmessung der Bestückelemente, beispielsweise SMD-Widerstände oder anderen SMD-Bauelemente. Ebenso ist die in dem Rumpf 51 ausgebildete Nut sehr schmal im Vergleich zu den Abmessungen der Bestückelemente. Daher werden die Bestückelemente sowohl von dem Rumpf 51 der starren Abdeckung 5 als auch von dem Teleskopstück 52 sicher zurückgehalten und können das Transportband nicht verlassen, solange sie entweder von dem Rumpf 51 oder dem Teleskopstück 52 bedeckt sind.

Aus Figur 3 ist ein Schnitt entlang der Linie I-I aus Figur 2 ersichtlich, welcher die Beweglichkeit des Teleskopstücks 52 relativ zu dem Rumpf 51 verdeutlicht.

Mit der aus den Figuren 2 und 3 ersichtlichen Ausführungsform der starren Abdeckung ist es möglich, Bestückelemente, über denen mittels der starren Abdeckung 5 die flexible Abdeckung 4 bereits entfernt worden ist, sukzessive einer Entnahmeeinrichtung 1 zum Entnehmen freizulegen.

Das Teleskopstück 52 kann beispielsweise mittels eines elektromagnetischen Aktuators (nicht gezeigt) bewegbar sein.

Die Erfindung beschränkt sich nicht auf die beispielhaft gezeigte Ausführungsform, sondern wird in ihrer allgemeinsten Form durch Anspruch 1 definiert.

## Patentansprüche

1. Gurtförderer mit einer Freilegevorrichtung für eine Bestückanlage, wobei bei der Bestückanlage ein mit Bestückelementen beladenes Transportband (2) mit einer flexiblen Abdeckung (4) versehen ist, von welcher die Bestückelemente entlang eines ersten Längsabschnitts des Transportbandes (2) bis zu einer Abziehposition bedeckt sind, und die Bestückanlage eine längs des Transportbandes (2) verschiebbare Entnahmeeinrichtung (1) zur Entnahme von Bestückelementen aufweist,
wobei der Gurtförderer aufweist:
eine Freilegevorrichtung mit einer starren Abdeckung (5), von welcher mehrere Bestückelemente entlang eines sich an die Abziehposition anschließenden Entnahmeabschnitts des Transportbandes (2) bedeckbar sind, **dadurch gekennzeichnet, dass** der Entnahmeabsch mitt mehrere Entnahmepositionen aufweist und die starre Abdeckung (5) längs zum Transportband (2) um eine Mehrzahl von Bestückelemente-Abständen relativ zum festsfehen den Transportaband verschiebbar ist, so daß von der starren Abdeckung eine der Mehrzahl entsprechende Anzahl n von Bestückelementen ohne Verschiebung des Transportbandes sukzessive freilegbar ist.

2. Gurtförderer nach Anspruch 1, **dadurch gekennzeichnet, daß** die Länge der starren Abdeckung variabel einstellbar ist.

3. Gurtförderer nach Anspruch 2, **dadurch gekennzeichnet, daß** die starre Abdeckung teleskopartig ausgebildet ist.

4. Gurtförderer nach Anspruch 2 oder 3, **dadurch gekennzeichnet, daß** die Abdeckungen (4, 5) derart aneinander gekoppelt sind, daß durch Verschieben der starren Abdeckung (5) deren Position dieselbe Änderung erfährt wie die Abziehposition .

5. Gurtförderer nach Anspruch 1 bis 4,
bei dem die starre Abdeckung (5) eine Ausnehmung (6) aufweist, durch die die flexible Abdeckung (4) an der Abziehposition auf die vom Transportband (2) abgewandte Seite der starren Abdeckung (5) durchgeführt ist.

6. Gurtförderer nach Anspruch 1 bis 5,
bei dem die starre Abdeckung (5) an einen ihre Verschiebung steuernden Linearmotor oder Hubmagneten gekoppelt ist.

7. Verfahren zum Bestücken unter Verwendung des Gurtförderers nach einem der Ansprüche 1 bis 6,
bei dem von der starren Abdeckung das am weitesten von der Abziehposition entfernte Bestückelement freigelegt wird, die Entnahmeeinrichtung (1), ausgehend von einer Startposition in dem Entnahmeabschnitt über dem von der starren Abdeckung (5) freigelegten Bestückelement
sich in Richtung Abziehposition hin zu einer Endposition bewegt, und von der starren Abdeckung (5) sukzessive eine Anzahl von insgesamt n Bestückelementen freigegeben werden, die von der Entnahmeeinrichtung (1) entnommen werden.

8. Verfahren nach Anspruch 7,
bei dem die Bestückelemente aus Vertiefungen (3) des Transportbandes (2) entnommen werden.

9. Verfahren nach Anspruch 7 oder 8,
bei dem nach Entnahme des n-ten Bestückelementes die Entnahmeeinrichtung (1) zur Startposition zurückkehrt und das Transportband (2) zusammen mit der starren und der flexiblen Abdeckung (4, 5) um eine entsprechende Strecke in gleicher Richtung verschoben wird.

## Claims

1. Belt conveyor having an uncovering apparatus for a pick-and-place installation, it being the case that, in the pick-and-place installation, a transporting belt (2) loaded with pick-and-place elements is provided with a flexible covering (4) by which the pick-and-place elements are covered along a first longitudinal section of the transporting belt (2) as far as a drawing-off position, and the pick-and-place installation has a removal arrangement (1) which can be displaced along the transporting belt (2) and is intended for removing pick-and-place elements, it being the case that the belt conveyor has:
an uncovering apparatus with a rigid covering (5) by which a plurality of pick-and-place elements can be covered along a removal section of the transporting belt (2), which adjoins the drawing-off position, **characterized in that** the removal section has a plurality of removal positions, and the rigid covering (5) can be displaced longitudinally in relation to the transporting belt (2) by a plurality of pick-and-place element spacings relative to the stationary transporting belt, with the result that a number n of pick-and-place elements which corresponds to the plurality can be uncovered successively by the rigid covering without the transporting belt being displaced.

2. Belt conveyor according to Claim 1, **characterized in that** the length of the rigid covering can be adjusted in a variable manner.

3. Belt conveyor according to Claim 2, **characterized in that** the rigid covering is of telescopic design.

4. Belt conveyor according to Claim 2 or 3, **characterized in that** the coverings (4, 5) are coupled to one another such that, by virtue of the rigid covering (5) being displaced, the position of the latter undergoes the same change as the drawing-off position.

5. Belt conveyor according to Claims 1 to 4, in the case of which the rigid covering (5) has a cutout (6) through which the flexible covering (4) is guided, at the drawing-off position, onto that side of the rigid covering (5) which is directed away from the transporting belt (2).

6. Belt conveyor according to Claims 1 to 5, in the case of which the rigid covering (5) is coupled to a linear motor, which controls its displacement, or lifting magnet.

7. Pick-and-place method using the belt conveyor according to one of Claims 1 to 6, in the case of which the rigid covering uncovers the pick-and-place element furthest away from the drawing-off position, the removal arrangement (1), starting from a starting position in the removal section above the pick-and-place element uncovered by the rigid covering (5), moves, in the direction of the drawing-off position, towards an end position, and the rigid covering (5) successively uncovers a number comprising a total of n pick-and-place elements, which are removed by the removal arrangement (1).

8. Method according to Claim 7, in the case of which the pick-and-place elements are removed from depressions (3) of the transporting belt (2).

9. Method according to Claim 7 or 8, in the case of which, following removal of the nth pick-and-place element, the removal arrangement (1) returns to the starting position and the transporting belt (2), together with the rigid and the flexible coverings (4, 5), is displaced by a corresponding amount in the same direction.

## Revendications

1. Convoyeur à courroie avec un mécanisme de dégarnissage pour une installation d'équipement, une bande transporteuse (2) chargée d'éléments à planter étant, dans l'installation d'équipement, munie d'une couverture souple (4), qui recouvre les éléments à planter le long d'une première section longitudinale de la bande transporteuse (2) jusqu'à une position de retrait et l'installation d'équipement comportant un dispositif d'extraction (1), qui est destiné à extraire des éléments à planter et qui peut se déplacer le long de la bande transporteuse (2),
le convoyeur à courroie comportant:
un mécanisme de dégamissage avec une couverture rigide (5) pouvant recouvrir plusieurs éléments à planter le long d'une section d'extraction de la bande transporteuse (2) qui suit la position d'enlèvement,
**caractérisé par le fait que** la section d'extraction comporte plusieurs positions d'extraction et que la couverture rigide (5) peut se déplacer le long de la bande transporteuse (2) d'une pluralité d'écarts entre les éléments à planter, par rapport à la bande transporteuse immobile, si bien que la couverture rigide peut découvrir, les uns après les autres, un nombre n d'éléments à planter correspondant à la pluralité sans que la bande transporteuse ne se déplace.

2. Convoyeur à courroie selon la revendication 1 **caractérisé par le fait que** la longueur de la couverture rigide peut être réglée d'une façon variable.

3. Convoyeur à courroie selon la revendication 2 **caractérisé par le fait que** la couverture rigide est conçue d'une façon télescopique.

4. Convoyeur à courroie selon la revendication 2 ou 3 **caractérisé par le fait que** les couvertures (4, 5) sont couplées l'une à l'autre de telle sorte que, par déplacement de la couverture rigide (5), sa position est modifiée de la même façon que la position d'enlèvement.

5. Convoyeur à courroie selon la revendication 1 à 4
dans lequel la couverture rigide (5) comporte une ouverture (6) à travers laquelle est guidée, à la position d'enlèvement, la couverture souple (4) vers le côté opposé à la bande transporteuse (2) de la couverture rigide (5).

6. Convoyeur à courroie selon la revendication 1 à 5
dans lequel la couverture rigide (5) est couplée à un moteur linéaire ou à un électro-aimant qui commandent son déplacement.

7. Procédé d'équipement utilisant le convoyeur à courroie selon l'une des revendications 1 à 6
dans lequel la couverture rigide dégarnit l'élément à planter le plus éloigné de la position d'enlèvement,
le dispositif d'extraction (1) se déplace, en partant d'une position de départ dans la section d'extraction au-dessus de l'élément à planter dégarni par la couverture rigide (5), dans la direction allant de la position d'enlèvement, vers une position finale et
la couverture rigide (5) dégarnit les uns après les autres un nombre total de n éléments à planter, qui sont extraits par le dispositif d'extraction (1).

8. Procédé d'équipement selon la revendication 7
dans lequel les éléments à planter sont extraits de creux (3) de la bande transporteuse (2).

9. Procédé d'équipement selon la revendication 7 ou 8
dans lequel, après l'extraction du n-ième élément à planter, le dispositif d'extraction (1) retourne à la position de départ et la bande transporteuse (2) est déplacée, en commun avec la couverture rigide et la couverture souple (4, 5), d'une longueur correspondante dans la même direction.
